# DEMANDE DE BREVET EUROPEEN

(11) **EP 1 309 087 A1**
(43) Date de publication de la demande: **07.05.2003**
(21) Numéro de dépôt: 02292561.4
(22) Date de dépôt: 16.10.2002
(51) Int. Cl.: H03K 17/082

(54) **Dispositif de protection contre les surtensions d'un composant de puissance**

(30) Priorité: 05.11.2001 FR 0114271
(71) Demandeur: Alstom, 75116 Paris (FR)
(72) Inventeur: Coiret, Jean-Yves, 65800 Aureilhan (FR); Refalo, Thierry, 65190 Tournay (FR)
(74) Mandataire: Gosse, Michel

(57) **Abrégé**

Dispositif de protection contre les surtensions d'un composant semi-conducteur de puissance (4) muni d'un collecteur (C), d'un émetteur (E) et d'une grille de commande (G), ledit dispositif comportant un circuit de protection, connecté en parallèle entre le collecteur (C) et la grille de commande (G), ledit circuit de protection comprenant une branche principale (1) comportant au moins deux diodes Zener connectées en série et une branche secondaire (2), munie d'un condensateur (5), connectée en parallèle sur au moins une desdites diodes Zener de la branche principale (1), caractérisé en ce que ledit circuit de protection comporte une branche supplémentaire (3) comprenant une résistance (8) qui est connectée en parallèle avec ledit condensateur (5).

## Description

L'invention se rapporte à un dispositif de protection contre les surtensions d'un composant semi-conducteur de puissance. L'invention trouve notamment son application dans les convertisseurs de puissance du domaine ferroviaire.

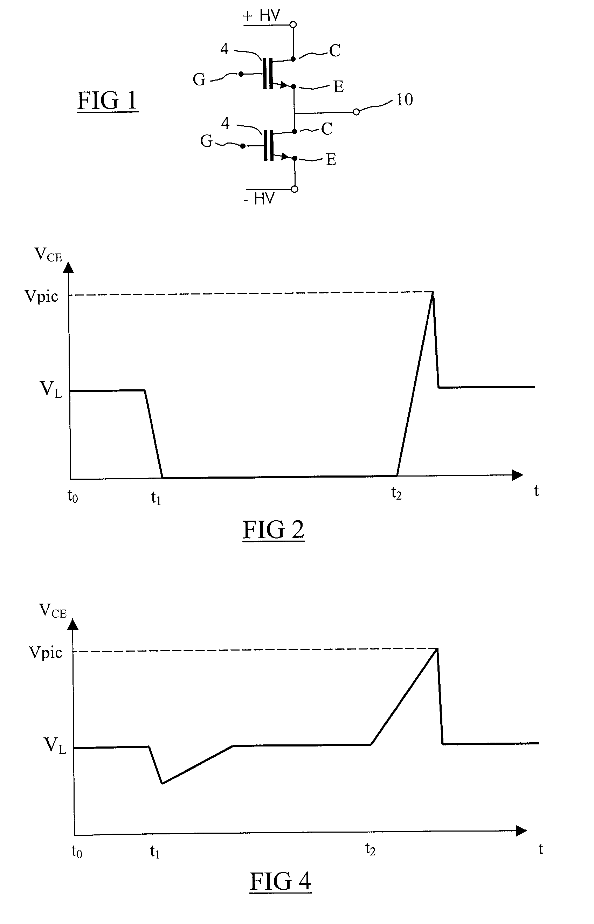

La plupart des convertisseurs du domaine ferroviaire destinés à alimenter des moteurs de traction sont maintenant réalisées à partir de composants IGBT. Un exemple de bras d'un tel convertisseur est représenté schématiquement sur la figure 1 où l'on peut voir que le bras de convertisseur est constitué d'un premier composant IGBT 4, présentant un collecteur C soumis extérieurement à un potentiel +HV et présentant un émetteur E connecté à un moteur de traction 10, et d'un second composant IGBT 4 présentant un collecteur C connecté au moteur de traction 10 et présentant un émetteur E soumis à un potentiel -HV. Chaque composant IGBT 4 comporte une grille de commande G reliée à un circuit de commande non représenté.

Un tel convertisseur présente en fonctionnement normal des composants IGBT 4 dont le fonctionnement à la commutation est illustré sur la figure 2 qui représente en fonction du temps, la tension V_{CE} entre le collecteur C et l'émetteur E du composant IGBT 4.

Conformément à cette figure, entre les instants t₀ et t_{1,} le composant IGBT est dans un état bloqué et une tension de ligne V_{L} est appliquée aux bornes du composant IGBT. A l'instant t₁, le composant IGBT est commandé à la fermeture et devient passant, la tension à ses bornes devenant sensiblement nulle. A l'instant t₂, le composant IGBT est commandé à l'ouverture et passe à l'état bloqué, la tension V_{CE} aux bornes du composant IGBT augmente alors très rapidement provoquant une surtension V_{pic}. Or, une tension V_{pic} supérieure à la tension maximale admissible par le composant IGBT provoque sa destruction et donc la mise hors service du convertisseur de puissance.

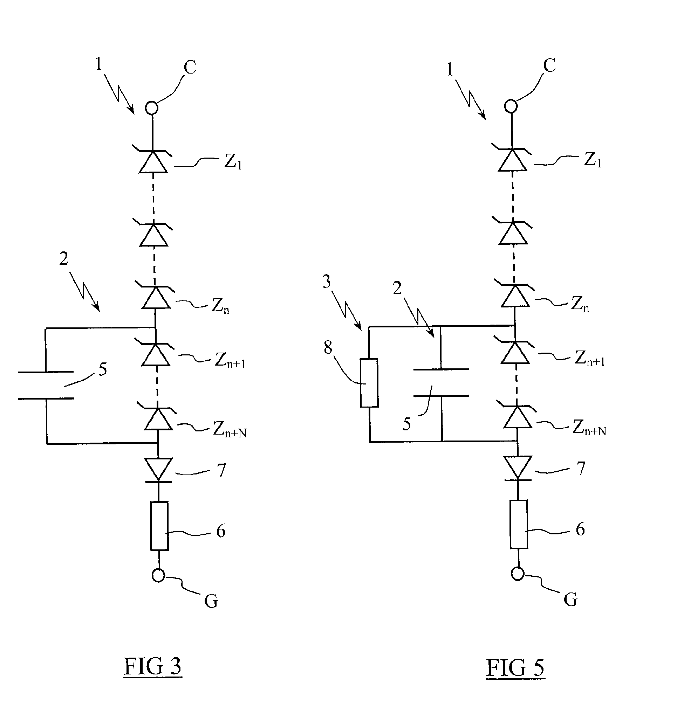

Aussi, il est connu de l'art antérieur de protéger les composants IGBT des convertisseurs de puissance contre les surtensions en connectant un circuit de protection, tel que représenté à la figure 3, entre le collecteur C et la grille de commande G des composants IGBT 4 de la figure 1. Conformément à cette figure 3, le circuit de protection selon l'art antérieur comporte une branche principale 1 comprenant n+N diodes Zener connectées en série, numérotées Z₁ à Z_{n+N}, chacune de ces diodes Zener possédant une cathode orientée vers le collecteur C de l'IGBT. La branche principale 1 comprend de plus une résistante 6 et une diode 7, dite de protection, connectées en série avec les n+N diodes Zener précédemment décrites, la diode de protection 7 étant disposée en sens inverse par rapport aux diodes Zener Z₁ à Z_{n+N}.

Le circuit de protection comporte également une branche secondaire 2 constituée d'un condensateur 5 qui est connecté en parallèle aux bornes des N diodes Zener Zₙ₊₁ à Z_{n+N} de la branche principale 1.

Un tel circuit de protection, qui réalise un écrêtage de la tension, possède un seuil de conduction statique V_{statique} et un seuil de conduction dynamique V_{dynamique} répondant aux relations suivantes, en considérant que les diodes Zener Z₁ à Z_{n+N} de la branche principale 1 possèdent des caractéristiques identiques :

Vₛₜₐₜᵢₐᵤₑ = (n+N)∗Vz, où Vz est le seuil de tension appliqué aux bornes d'une diode

Zener de la branche principale à partir duquel la diode Zener devient conductrice.

Et V_{dynamique} = n∗Vz, ce seuil dynamique étant obtenu par l'effet du condensateur connecté en parallèle sur les N diodes Zener Zₙ₊₁ à Z_{n+N}, ce condensateur venant court-circuiter ces diodes lors des changements rapides d'états du composant IGBT auquel est connecté le circuit de protection.

La valeur du seuil V_{statique} est choisie en fonction du calibre des composants IGBT et est généralement supérieure à la valeur maximale de la tension ligne V_{L} de fonctionnement normal du bras de convertisseur.

La valeur du seuil V_{dynamique} est choisie en fonction du calibre des composants

IGBT et peut être dans certain cas inférieure à la valeur maximale de la tension ligne de fonctionnement normal du bras.

Un tel circuit de protection permet en temps normal de remédier aux problèmes de surtensions dans le composant IGBT. En effet, le potentiel de la grille de commande G d'un composant IGBT 4 étant proche du potentiel de son émetteur E, toute variation brusque de la tension entre l'émetteur E et le collecteur C du composant IGBT 4 se retrouve aux bornes du circuit de protection qui est branché entre le collecteur C et la grille G. Or, avec un tel circuit de protection, lorsque la tension V_{CE} atteint le seuil V_{dynamique} après la commande d'ouverture du composant IGBT 4 à l'instant t₂, les n diodes Zener Z₁ à Zₙ deviennent conductrices et dérivent un courant qui traverse le condensateur 5 en shuntant les N diodes Zener Zₙ₊₁ à Z_{n+N}, le condensateur 5 s'étant initialement déchargé pendant la période de fermeture du composant IGBT 4. Ce courant est réinjecté dans la grille de commande G du composant IGBT 4, ce qui permet de ralentir le changement d'état de celui-ci et donc de limiter la surtension à ces bornes.

Toutefois, la demanderesse s'est rendu compte qu'un tel circuit de protection, s'il est efficace en fonctionnement normal des composants IGBT, présente l'inconvénient d'être inefficace pour lutter contre les surtensions lorsque le composant IGBT se trouve dans un état dé-saturé. Un tel état de dé-saturation du composant IGBT se produit à partir du moment où le composant IGBT conduit durant sa phase fermée un courant égal à environ six à sept fois la valeur du courant nominal, cette situation pouvant être provoquée par exemple par un défaut à la charge connectée ou par un court-circuit de bras.

Dans un tel cas, le composant IGBT bien qu'il soit à l'état fermé, possède une tension à ses bornes qui devient rapidement égale à la tension de ligne V_{L} ainsi que cela est représenté sur la figure 4. Le composant IGBT dissipe alors une puissance instantanée très importante qui peut très rapidement provoquer la casse de celui-ci. Dans une telle situation, il est donc urgent d'ouvrir l'interrupteur constitué par le composant IGBT tout en essayant de limiter la surtension.

Cependant, le phénomène de dé-saturation étant accompagné par une tension importante aux bornes du composant IGBT, le condensateur 5 du circuit de protection selon l'art antérieur est dans un état chargé juste à l'instant t₂ de commande d'ouverture du composant IGBT et ne joue plus alors son rôle d'anticipation en ne permettant plus le passage de courant au delà du seuil dynamique V_{dynamique} du circuit de protection. Le circuit de protection ne réalise alors un écrêtage de la tension aux bornes du composant IGBT qu'à partir du seuil V_{statique} plus élevé, ce qui peut être fatal pour le composant IGBT, car la surtension n'est que très peu réduite, et peut entraîner la mise hors service du convertisseur.

Aussi, un but de la présente invention est de proposer un circuit de protection contre les surtensions qui soit efficace même lorsque le semi-conducteur de puissance est dans un état dé-saturé et qui soit simple et économique à réaliser.

A cet effet, l'invention a pour objet un dispositif de protection contre les surtensions d'un composant semi-conducteur de puissance muni d'un collecteur, d'un émetteur et d'une grille de commande, le dispositif comportant un circuit de protection connecté en parallèle entre le collecteur et la grille de commande, ce circuit de protection comprenant une branche principale comportant au moins deux diodes Zener connectées en série et une branche secondaire, munie d'un condensateur, connectée en parallèle sur au moins une des diodes Zener de la branche principale, caractérisé en ce que le circuit de protection comporte une branche supplémentaire comprenant une résistance qui est connectée en parallèle avec le condensateur.

Selon des modes particuliers de réalisation, le dispositif de protection contre les surtensions d'un composant semi-conducteur de puissance selon l'invention peut comprendre l'une ou plusieurs des caractéristiques suivantes prises isolément ou selon toutes les combinaisons techniquement possibles :
- la résistance est connectée directement aux bornes du condensateur ;
- la branche principale du circuit de protection comporte une succession de diodes Zener connectées en série parmi lesquelles quelques diodes sont shuntés par la branche secondaire comportant le condensateur ;
- le composant semi-conducteur de puissance est un composant IGBT ;

L'invention concerne également un convertisseur de puissance pour véhicule ferroviaire caractérisé en ce qu'il comprend au moins un composant semi-conducteur de puissance comportant un dispositif de protection contre les surtensions selon l'invention.

On comprendra mieux les buts, aspects et avantages de la présente invention, d'après la description donnée ci-après d'un mode particulier de réalisation de l'invention, présenté à titre d'exemple non limitatif, en se référant aux dessins annexés, dans lesquels :
- les figures 1 à 4, qui ont déjà été commentées, illustrent un bras de convertisseur de puissance, le fonctionnement des composants IGBT dans un tel bras ainsi qu'un dispositif de protection contre les surtensions selon l'art antérieur ;
- la figure 5 représente un dispositif de protection contre les surtensions selon l'invention, ce dispositif de protection étant connecté entre le collecteur et la grille de commande d'un composant IGBT du bras de convertisseur de la figure 1 non représenté sur cette figure.

Pour faciliter la lecture du dessin, seuls les éléments nécessaires à la compréhension de l'invention ont été représentés. Les mêmes éléments portent les mêmes références d'une figure à l'autre.

La figure 5 représente un dispositif de protection contre les surtensions selon l'invention qui est destiné à être connecté en parallèle entre le collecteur C et la grille de commande G de chacun des composants IGBT 4 de la figure 1 et qui remédie aux inconvénients de l'art antérieur.

Conformément, au mode de réalisation particulier de l'invention représenté à la figure 5, le dispositif de protection est constitué d'un circuit de protection comportant une branche principale 1 et une branche secondaire 2 similaires à celles du circuit de l'art antérieur décrit à la figure 3.

Selon une caractéristique essentielle de l'invention, le circuit de protection comporte de plus une branche supplémentaire 3 constituée d'une résistance 8 qui est connectée en parallèle aux bornes du condensateur 5 de la branche secondaire 2.

Un tel dispositif de protection présente l'avantage d'avoir un seuil dynamique qui reste réactif lorsque le composant IGBT 4 est dans un état dé-saturé. En effet, la résistance 8 permet de dévier un courant très faible qui s'ajoute aux courants de fuite des N diodes Zener Zₙ à Z_{n+N} en parallèle, ce qui provoque la décharge du condensateur 5 pendant la phase de dé-saturation du composant IGBT 4. Ainsi, dans le cas de dé-saturation du composant IGBT 4, juste avant l'ouverture de celui-ci, le condensateur 5 n'est pas chargé ou seulement faiblement chargé. Le circuit de protection est alors actif des que la tension V_{CE} atteint le seuil V_{dynamique} ce qui permet de réduire la surtension sur le composant IGBT 4 de la même façon que dans le cas d'un fonctionnement normal du bras. Des essais pour une tension continue de ligne de 900 V avec un circuit de protection possédant un seuil statique V_{statique} réglé à 1200 V et un seuil dynamique V_{dynamique} réglé à 900 V ont permis de montrer que la surtension est ainsi réduite de plus de 32 % avec le dispositif de la figure 5 par rapport au dispositif de l'art antérieur.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

## Revendications

1. Dispositif de protection contre les surtensions d'un composant semi-conducteur de puissance (4) muni d'un collecteur (C), d'un émetteur (E) et d'une grille de commande (G), ledit dispositif comportant un circuit de protection connecté en parallèle entre le collecteur (C) et la grille de commande (G), ledit circuit de protection comprenant une branche principale (1) comportant au moins deux diodes Zener connectées en série et une branche secondaire (2), munie d'un condensateur (5), connectée en parallèle sur au moins une desdites diodes Zener de la branche principale (1), **caractérisé en ce que** ledit circuit de protection comporte une branche supplémentaire (3) comprenant une résistance (8) qui est connectée en parallèle avec ledit condensateur (5).

2. Dispositif de protection contre les surtensions d'un composant semi-conducteur de puissance selon la revendication 1, **caractérisé en ce que** ladite résistance (8) est connectée directement aux bornes dudit condensateur (5).

3. Dispositif de protection contre les surtensions selon la revendication 1, **caractérisé en ce que** la branche principale (1) du circuit de protection comporte une succession de diodes Zener connectées en série parmi lesquelles quelques diodes sont shuntés par la branche secondaire (2) comportant ledit condensateur (5).

4. Dispositif de protection contre les surtensions selon l'une quelconque des revendications 1 à 2, **caractérisé en ce que** ledit composant semi-conducteur de puissance (4) est un composant IGBT.

5. Convertisseur de puissance pour véhicule ferroviaire **caractérisé en ce qu'**il comprend au moins un composant semi-conducteur de puissance comportant un dispositif de protection contre les surtensions selon l'une quelconque des revendications 1 à 4
